(19) **Europäisches Patentamt**

**European Patent Office**

**Office européen des brevets**

(11) **EP 1 630 616 A2**

(12) **EUROPEAN PATENT APPLICATION**

(43) Date of publication:
01.03.2006 Bulletin 2006/09

(51) Int Cl.:
*G03F 7/20* (2006.01)

(21) Application number: 05018430.8

(22) Date of filing: 24.08.2005

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **27.08.2004 US 927394**

(71) Applicant: **ASML Holding N.V.
5504 DR Veldhoven (NL)**

(72) Inventors:
• **Ryzhikov, Lev
Norwalk
Connecticut 06851 (US)**
• **Vladimirsky, Yuli
Weston
Connecticut 06883 (US)**

(74) Representative: **Grünecker, Kinkeldey,
Stockmair & Schwanhäusser
Anwaltssozietät
Maximilianstrasse 58
80538 München (DE)**

(54) **System for reducing movement induced disturbances in immersion lithography**

(57)     In an immersion lithography system (100), a moveable substrate unit (110) is formed from a substrate (120) and at least one optical element (116), with immersion liquid (118) between them. The immersion liquid and the optical element move in unison with the substrate. Movement of the substrate unit reduces refractive index disturbance produced by turbulence during exposure scans. The projection optical system is enhanced with a dynamic axial compensation group (106). Elements in the dynamic axial compensation group can move to compensate aberrations caused by deviation of axial symmetry due to movement of the optical element in the substrate unit. The space in the substrate unit filled with immersion liquid may be dynamically controlled to provide proper working distance. If the optical element in the substrate unit has optical power, both resolution and depth of focus may be enhanced. Even if the optical element has no optical power, depth of focus may still be enhanced.

**FIG. 1**

**EP 1 630 616 A2**

**Description**

BACKGROUND OF THE INVENTION

Field of the Invention

The present invention relates to photolithography, and more particularly to a method and system for preventing aberrations in an immersion photolithography system.

Related Art

Optical lithography, using lens systems and catadioptric systems, is used extensively in the semiconductor manufacturing industry for the printing of circuit patterns. The practical limits of optical lithography assume that the medium through which imaging is occurring is air. This practical limit is defined by the equation

$$\Lambda = \frac{\lambda}{4 \cdot n \cdot NA}, \qquad\qquad \text{(Eq. 1)}$$

where $\lambda$ is the wavelength of incident light, $NA$ is the numerical aperture of the projection optical system, and $n$ is the index of refraction of the medium (where 4 is used instead of 2 when off-axis illumination is used). The gas interface between the final lens element and the substrate surface limits the maximum resolution of the optical system to a numerical aperture of less than 1.0.

Thus, by introducing a liquid between a last lens element of the projection optical system and a substrate being imaged, the index of refraction $n$ changes. This enables enhanced resolution with a lower effective wavelength of the light source. For example, immersion lithography effectively lowers a 157 nm light source to a 115 nm wavelength (for example, for $n$ = 1.365), enabling the printing of critical layers with the same photolithographic tools that the industry is accustomed to using.

Similarly, immersion lithography can push 193 nm lithography down to, for example, 145 nm (for $n$ = 1.33). Thus, 435 nm, 405 nm, 365 nm, 248 nm, 193 nm and 157 nm tools can all be used to achieve effectively better resolution and "extend" the usable wavelengths. As a result, the need for large amounts of $CaF_2$, hard pellicles, a nitrogen purge, etc., can be avoided. Also, depth of focus can be increased by the use of liquid immersion, which may be useful, for example, for LCD panel manufacturing.

However, despite the promise of immersion photolithography, a number of problems remain, which have so far retarded the advance of immersion photolithography systems. One problem of existing immersion photolithography systems is that movement of the substrate through the immersion liquid produces turbulence, such as bubbles and cavitation. This decreases the homogeneity of the refractive index between the projection optical system and the substrate, and causes aberrations in the exposure. These aberrations can be lessened by slowing the movement of the substrate through the immersion liquid. However, this prevents sufficiently high throughput for current standards.

Therefore, what is needed is a method and system for reducing aberrations caused by movement of a substrate through the immersion liquid.

SUMMARY OF THE INVENTION

Turbulence caused by movement between a substrate and immersion liquid can be avoided by combining the exit optical element of the projection optical system ("POS") and the substrate, with immersion liquid between them, into a single moveable unit. Depending on whether resolution enhancement, depth of focus enhancement, or both is desired, the exit element may or may not have optical power.

The POS in the immersion lithography system may be enhanced with a dynamic axial compensation group in addition to the pattern generator, optical groups, and moveable substrate unit. The dynamic axial compensation group provides continuous correction of the POS optical train in order to compensate for aberrations caused by deviation of axial symmetry. The immersion liquid-filled space between the substrate and the movable optical element may be dynamically controlled to provide proper working distance.

In one embodiment, the movable substrate unit is used in a full field step and scan exposure. The moveable substrate unit includes a full field optical element having optical power.

In another embodiment, the movable substrate unit is used in a full field step exposure. The moveable substrate unit includes a sub-field optical element with optical power to minimize compensation.

In still another embodiment, the movable substrate unit is used in a full field step and scan exposure. The moveable substrate unit includes a full field optical element having no optical power. This embodiment is used when increased depth of focus, but not increased resolution, is sufficient.

Further embodiments, features, and advantages of the present invention, as well as the structure and operation of the various embodiments of the present invention, are described in detail below with reference to the accompanying drawings.

BRIEF DESCRIPTION OF THE DRAWINGS/FIGURES

The accompanying drawings, which are incorporated herein and form a part of the specification, illustrate the present invention and, together with the description, further serve to explain the principles of the invention and to enable a person skilled in the pertinent art to make and use the invention.

**FIG. 1** is a block diagram of an exposure system according to an embodiment of the present invention.

**FIG. 2** is a block diagram of an exposure system according to another embodiment of the present invention.

**FIG. 3** is a block diagram of an exposure system according to yet another embodiment of the present invention.

**FIG. 4** is a flowchart of a method according to an embodiment of the present invention.

**FIG. 5** is a block diagram of a typical immersion lithography system.

The present invention will be described with reference to the accompanying drawings. The drawing in which an element first appears is typically indicated by the leftmost digit(s) in the corresponding reference number.

DETAILED DESCRIPTION OF THE INVENTION

While specific configurations and arrangements are discussed, it should be understood that this is done for illustrative purposes only. A person skilled in the pertinent art will recognize that other configurations and arrangements can be used without departing from the spirit and scope of the present invention. It will be apparent to a person skilled in the pertinent art that this invention can also be employed in a variety of other applications.

Lithography is a process used to create features on the surface of substrates. Such substrates can include those used in the manufacture of flat panel displays (e.g., liquid crystal displays), semiconductor wafers, circuit boards, various integrated circuits, print heads, macro/nano-fluidic substrates, and the like. During lithography, a substrate, which is disposed on a substrate stage, is exposed to an image projected onto the surface of the substrate by exposure optics located within a lithography apparatus.

The projected image produces changes in the characteristics of a layer, for example photoresist, deposited on the surface of the substrate. These changes correspond to the features projected onto the substrate during exposure. Subsequent to exposure, the layer can be etched or otherwise processed to produce a patterned layer. The pattern corresponds to those features projected onto the substrate during exposure. The patterned layer is then used to remove or further process exposed portions of underlying structural layers within the substrate, such as conductive, semiconductive, or insulative layers. This process is repeated, together with other steps, until the desired features have been formed on the surface, or in various layers, of the substrate.

Step-and-scan technology works in conjunction with a projection optical system ("POS") that has a narrow imaging slot. Rather than expose the entire substrate at one time, individual fields are scanned onto the substrate one at a time. This is accomplished by moving the substrate and reticle simultaneously such that the imaging slot is moved across the field during the scan. The substrate stage must then be asynchronously stepped between field exposures to allow multiple copies of the reticle pattern to be exposed over the substrate surface. In this manner, the quality of the image projected onto the substrate is maximized.

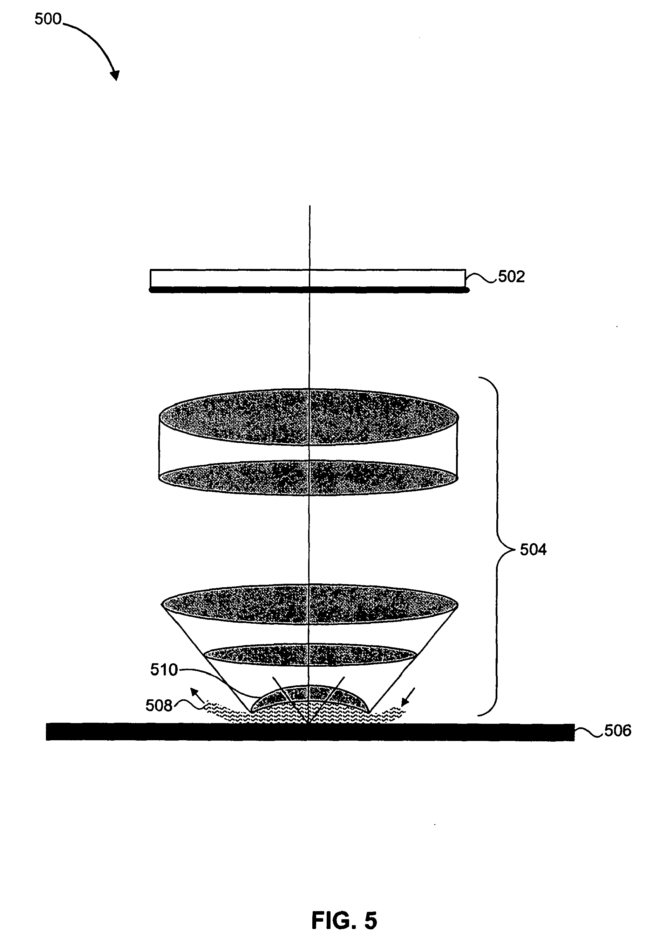

In immersion lithography systems, liquid is injected into the space between the POS exit window and the substrate surface. **FIG. 5** is a block diagram of a typical immersion lithography system 500. System 500 includes a pattern generator 502, a POS 504, and a substrate 506. In order to completely expose substrate 506, substrate 506 moves relative to POS 504. Immersion liquid 508 fills the space between substrate 506 and an exit POS element 510. Typically, immersion liquid 508 is circulated through the space while substrate 506 moves. Because of turbulence caused by movement of substrate 506 in relation to immersion liquid 508, the refractive index of immersion liquid 508 is not constant throughout the liquid. This disturbance of refractive index produces aberrations in the exposure pattern.

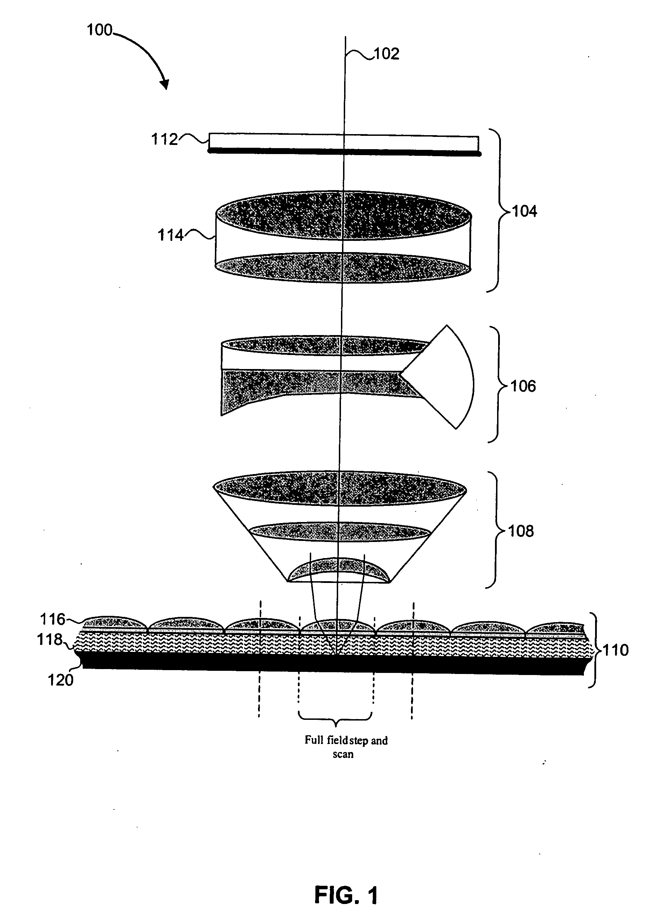

According to the present invention, turbulence within the immersion liquid of a lithography system can be reduced by forming a single movable unit from at least one optical element and the substrate, with the immersion liquid between them. **FIG. 1** is a block diagram of an exposure system 100 according to an embodiment of the present invention. An exposure beam 102 is represented by a line extending through the diagram. Exposure beam 102 may be a laser having a wavelength, such as an ultraviolet wavelength, that is not in the visible region. An example application of the present invention uses wavelengths which include, but are not limited to, 248 nm, 193 nm, and 157 nm. Additionally, exposure beam 102 may be generated by, for example, a pulsed laser or a continuous wave laser. Exposure system 100 includes a pattern generator group 104, a dynamic axial compensation group 106, an optical group 108, and a moveable substrate unit 110.

Pattern generator group 104 includes a pattern generator 112 and an optical group 114. Pattern generator 112 may be, for example, a reticle or a spatial light modulator ("SLM", e.g., a digital micromirror device ("DMD"), a reflective liquid crystal display ("LCD"), a grading light valve ("GLV"), or the like). Pattern generator 112 injects an exposure pattern into exposure beam 102. Optical group 114 is part of the POS. Optical group 114 further conditions the light in exposure beam 102 to direct and focus exposure beam 102 through system 100.

After leaving optical group 114, exposure beam 102 enters dynamic axial compensation group 106. In traditional exposure systems, the last element in the POS does not move, and an exposure beam follows a constant path (the "exposure axis"). In the embodiment of **FIG. 1,** as will be further described below, substrate unit 110 moves, for example, horizontally and/or vertically. This results in some axis curvature due to the optical power of substrate unit 110. Dynamic axial compensation group 106 corrects for aberrations caused by this deviation of axial symmetry. The lenses in dynamic axial compensation group 106 are shown grouped together in **FIG. 1.** Even so, a person of skill in the pertinent art will recognize that they could also be separated in the physical implementation and/or incorporated into one or both of optical groups 114 and 108. The lenses in dynamic axial compensation group 106 can move (e.g., shift, rotate, tilt, etc.) to provide proper compensation for any axial displacement. This movement may be based on expected movement of substrate unit 110 or may be the result of a feedback system.

Exposure beam 102 next passes through optical group 108, part of the POS which further conditions and focuses the beam for substrate exposure. Exposure beam 102 continues to moveable substrate unit 110.

Moveable substrate unit 110 includes a lens array 116, immersion liquid 118, and a substrate 120, all of which move in unison. Lens array 116 and substrate 120 may be attached to each other or unattached. Exposure beam 102 from optical group 108 passes through lens array 116 and immersion liquid 118 to expose its pattern onto substrate 120. In typical immersion systems, the exit lens of the POS comes in contact with the immersion liquid. The exit lens is typically a very strong lens, such as a bowl lens. In the embodiment of **FIG. 1,** the POS exit element that contacts immersion liquid 118 is lens array 116. So that minimal correction will be required by dynamic axial compensation group 106, lens array 116 may have a low optical power. Additional optics may be added to optical group 114 and/or 108 to counter any weakness of lens array 116.

System 100 is a full field step and scan system. Thus, an entire field on the substrate is exposed in a scanning process. Once the scan of the field is complete, system 100 steps to the next field. Each field may be, for example, 25-32 mm. As shown in **FIG. 1,** individual lenses, such as lens 122, in lens array 116 may be approximately the same size as the field. Each field would thus be scanned through a single lens in lens array 116, with each field having its own lens. Other variations of the step and scan approach will become apparent to a person of ordinary skill in the art based on the description herein without departing from the spirit and scope of the present invention.

The gap between lens array 116 and substrate 120 may be approximately 50 $\mu$m, although larger or smaller dimensions may also be used. Water, such as deionized water, may be used for 193 nanometer lithography, since it is relatively lossless at 193 nm. One of skill in the relevant art will recognize that other liquids, for example, cyclo-octane, Foemblin oil, and perfluoropolyether fluids, may be used. For 157 nm lithography, losses within the liquid are a concern. This tends to require smaller gaps between lens array 116 and substrate 120. In the case of 157 nm lithography, the space between lens array 116 and substrate 120 may be 50 $\mu$m or less.

Immersion liquid layer 118 may be retained by, for example, a containment ring (not shown). A containment ring may form an edge or side(s) of a container with lens array 116 and substrate 120 forming opposite faces of the container. Alternatively, adhesion may be used to retain an amount of immersion liquid. Depending upon the orientation of system 100 (whether lens array 116 is located above or below substrate 120), immersion liquid may rest on the surface of either substrate 120 or lens array 116. The volume of immersion liquid 118 would be held together on one surface due to surface tension, with the other surface contacting a meniscus of immersion liquid 118.

The volume of immersion liquid 118 may need to be adjusted for various effects such as, for example, changing focus. A containment ring may have inlets and/or outlets to adjust the volume of immersion liquid 118. The containment ring may also have additional reservoirs to accommodate added liquid. Feedback sensors may be included in immersion liquid 118 to correct for any errors in, for example, distance or focus. Most measurement devices used to maintain a level gap between projection optics and a substrate in typical lithography systems, such as interferometers or capacitance gauges, may also be used in substrate unit 110. An air gauge may also be used outside of the immersion liquid.

It will also be appreciated that the liquid may be removed completely, in the event that exposure of the substrate calls for dry exposure. For dry exposure, one or both of optical groups 114 and 108 may need to be adjusted accordingly (e.g., focus, spherical aberration, reduction in the numerical aperture, etc.).

During exposure, both pattern generator 112 and moveable substrate unit 110 move with respect to exposure beam 102. The ratio of speed between pattern generator movement and substrate unit movement depends on the magnification ratio of the system. For example, if system 100 has a magnification ratio of four, then pattern generator 112 will move four times faster than moveable substrate unit 110. As moveable substrate unit 110 moves, dynamic axial compensation group also moves to account for axis changes produced by the moving lens array 116. None of lens array 116, immersion liquid 118, and substrate 120 change position relative to each other. Therefore, the scanning movement of substrate 120 does not cause any turbulence in the liquid, and the overall distortion caused by the immersion liquid is reduced.

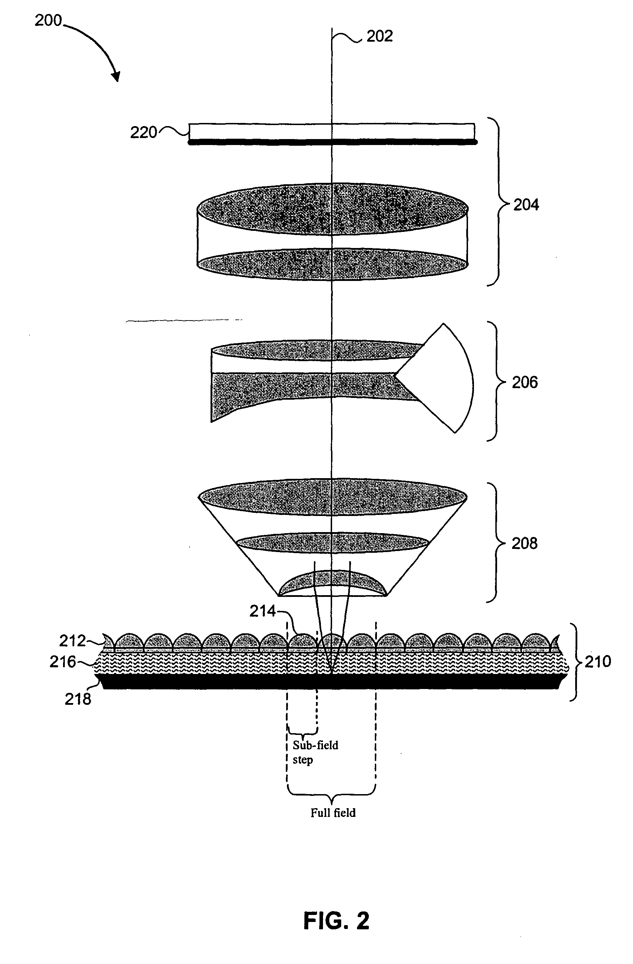

**FIG. 2** is a block diagram of an exposure system 200 according to a second embodiment of the present invention. Elements in pattern generator group 204, dynamic axial compensation group 206, and optical group 208 respectively correspond to pattern generator group 104, dynamic axial compensation group 106, and optical group 108 in system 100. Similarly, moveable substrate unit 210 includes an optical power lens array 212, immersion liquid 216, and a substrate 218.

Instead of being a step and scan system, system 200 is a step system. Thus, instead of scanning line-by-line through an entire field before stepping, system 200 breaks each field into sub-fields. System 200 steps to each sub-field, and exposes the entire sub-field without scanning. Pattern generator 220 may also need to be moved, since the full field is not imaged in one exposure.

To accommodate for the smaller sub-fields, lens array 212 includes a set of lenses, such as lens 214. Lens 214 is approximately the size of a sub-field. Since the lenses in lens array 212 are smaller than the field size, there will not be as much axial displacement. Therefore, axial displacement compensation group 206 will not be required to move as much as in system 100. Since less axial compensation is required due to field size, the optical power of each sub-field lens can be higher than in system 100. The optical power of lens array 212 will primarily be restricted by the desired quality of the stitching of the sub-fields. Otherwise, implementation of system 200 is similar to that described with respect to system 100.

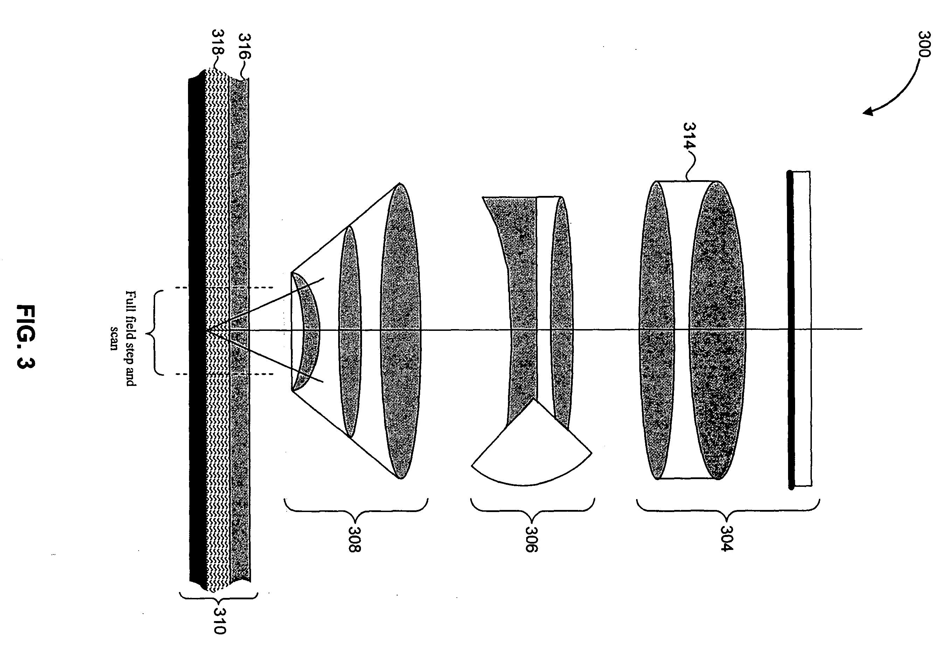

**FIG. 3** is a block diagram of an exposure system 300 according to a third embodiment of the present invention. System 300 is a full field step and scan system. Elements in pattern generator group 304, axial displacement compensation group 306, and optical group 308 respectively correspond to pattern generator 104, dynamic axial compensation group 106, and optical group 108 in system 100. Instead of including a lens array in contact with immersion liquid 318, substrate unit 310 includes a flat plate 316 having no optical power. Any optical power that a lens array would have added can instead be included in, for example, optical group 308.

Using flat plate 316 instead of a lens array makes this embodiment easy to add to pre-existing systems. All the optics necessary for exposure may be incorporated into optical groups 314 and 308, without separating any optics into moveable substrate unit 310. Further, since there is no optical power in flat plate 316, the optical axis will not be displaced. Use of axial displacement compensation group 306 is thus optional in the embodiment of **FIG. 3**. For use in a pre-existing system, the primary change will be in the magnification of the POS since the substrate will be located at a different distance from the exit lens in the POS. Otherwise, implementation of system 300 is similar to that described with respect to system 100.

Immersion systems having optical power elements in contact with the immersion liquid, such as systems 100 and 200, offer resolution enhancement, because the numerical aperture of the system is effectively increased. The resolution Δ available in an immersion lithography system is given by the following equation:

$$\Delta = \frac{\lambda_{wet}}{NA_{dry}}, \qquad\qquad (\text{Eq. 2})$$

where $\lambda_{wet}$ is the effective wavelength of the exposure light due to the presence of immersion liquid, and $NA_{dry}$ is the numerical aperture of the POS in air. $\lambda_{wet}$ can be determined using the following equation:

$$\lambda_{wet} = \frac{\lambda_{dry}}{n_{imm}}, \qquad\qquad (\text{Eq. 3})$$

where $\lambda_{dry}$ is the actual wavelength of the exposure light, and $n_{imm}$ is the refractive index of the immersion liquid.

Immersion systems also enhance depth of focus. The depth of focus available in an immersion lithography system is given by the following equation:

$$DOF = \frac{\lambda_{dry}}{n_{imm} \cdot NA_{dry}^2}.\qquad\text{(Eq. 4)}$$

Depth of focus can be improved in immersion systems according to the present invention regardless of whether they use substrate units having optical power. For example, since system 300 does not include an optical power element in contact with the immersion liquid, it likely cannot achieve resolution enhancement. However, it still may improve the depth of focus of the exposure. The enhanced depth of focus results in improved tolerances of other optics in the POS, such as optical groups 314 and 308.

Systems similar to the embodiments shown in **FIGS. 1, 2,** and **3** may be implemented in, for example, a dual scan system. In such an implementation, moveable substrate unit 110 can be assembled in a first stage, while the exposure occurs in a second stage. A person of skill in the relevant art will recognize, however, that the present invention may also be implemented in any single stage or multiple stage lithography system.

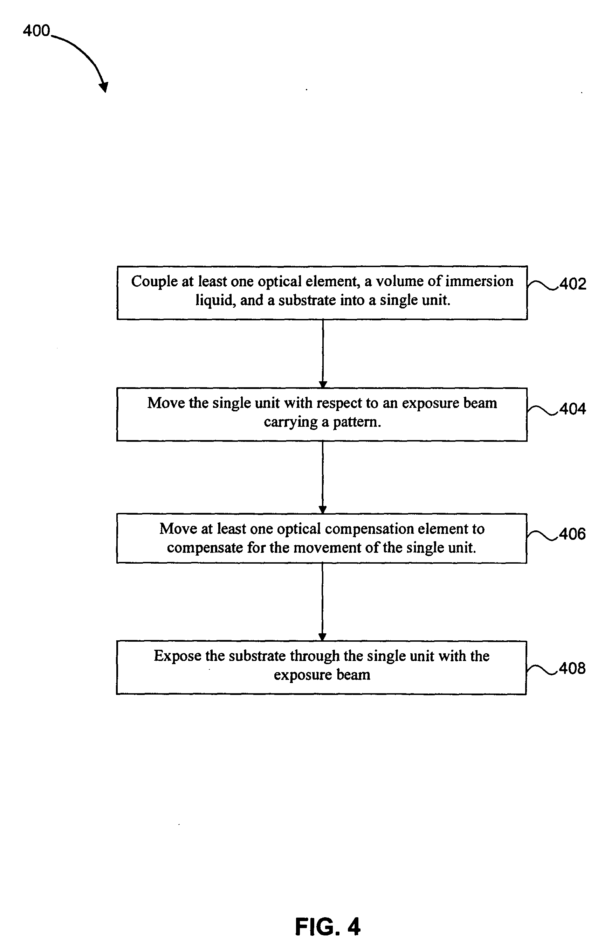

**FIG. 4** is a flowchart of an example lithography method 400 according to an embodiment of the present invention. In step 402, at least one optical element, a volume of immersion liquid, and a substrate are coupled into a single, moveable unit. The optical element may have optical power and be the exit element of a POS, as in systems 100 and 200. Alternatively, the optical element may have no optical power. The optical element, the immersion liquid, and the substrate may be coupled through optical contact, adhesion, or any other coupling method known to a person of skill in the relevant art.

In step 404, the single unit is moved with respect to an exposure beam carrying a pattern. The rate at which the single unit is moved depends on the magnification of the pattern desired. The movement also depends on whether the lithography system is a step system or a step and scan system. If it is a step system, the movement will include a stepping movement from one location to another, followed by a short stop while exposure occurs. If the system is a step and scan system, the movement will include a stepping movement from one location to a new location, followed by a continuous scanning movement within the new location.

In step 406, at least one optical compensation element is moved to compensate for the movement of the single unit. Movement of the compensation element may include, without limitation, any combination of shifting, rotating, and tilting. A full field exposure will require more compensation than a subfield exposure. If the single unit has no optical power, compensation is likely not needed and step 406 may be skipped.

In step 408, the substrate is exposed with the exposure beam carrying the pattern. Since the substrate is part of the single unit, the exposure beam passes through the optical element and the immersion liquid before reaching the substrate surface.

While various embodiments of the present invention have been described above, it should be understood that they have been presented by way of example only, and not limitation. It will be apparent to persons skilled in the relevant art that various changes in form and detail can be made therein without departing from the spirit and scope of the invention. Thus, the breadth and scope of the present invention should not be limited by any of the above-described exemplary embodiments, but should be defined only in accordance with the following claims and their equivalents.

**Claims**

1. A liquid immersion photolithography system, comprising:

   at least one optical element;
   a substrate; and
   a volume of immersion liquid placed between the at least one optical element and the substrate,

   wherein the at least one optical element, the substrate, and the volume of immersion liquid are configured to move in unison during imaging.

2. The photolithography system of claim 1, wherein the volume of immersion liquid is held between the at least one optical element and the substrate through adhesion.

3. The photolithography system of claim 1, wherein the at least one optical element and the substrate are adjacent to opposite sides of a container enclosing the volume of immersion liquid.

4. The photolithography system of claim 1, wherein the volume of immersion liquid is variable.

5. The photolithography system of claim 4, wherein the volume of immersion liquid can be varied to adjust for focus.

6. The photolithography system of claim 1, further comprising a compensation optical system to compensate for axial displacement.

7. The photolithography system of claim 6, wherein the compensation optical system comprises at least one lens having the capability of at least one of shifting, rotating or tilting.

8. The photolithography system of claim 6, wherein the compensation optical system is part of a projection optical system.

9. The photolithography system of claim 1, wherein the at least one optical element is a full field lens array having optical power.

10. The photolithography system of claim 1, wherein the at least one optical element is a sub-field lens array having optical power.

11. The photolithography system of claim 1, wherein the at least one optical element has no optical power.

12. The photolithography system of claim 1, wherein the at least one optical element is an exit lens of a projection optical system.

13. The photolithography system of claim 1, wherein the volume of immersion liquid rests on the surface of the substrate due to surface tension.

14. The photolithography system of claim 13, wherein a surface of the at least one optical element contacts a meniscus of the volume of immersion liquid.

15. The photolithography system of claim 1, wherein the volume of immersion liquid rests on the surface of the at least one optical element due to surface tension.

16. The photolithography system of claim 15, wherein a surface of the substrate contacts a meniscus of the volume of immersion liquid.

17. A method of printing a pattern on a substrate, comprising:

    (a) coupling at least one optical element, a volume of immersion liquid, and the substrate into a single unit;
    (b) moving the single unit with respect to an exposure beam carrying the pattern; and
    (c) exposing the substrate through the single unit with the exposure beam.

18. The method of claim 17, further comprising:

    (d) moving at least one optical compensation element to compensate for movement of the single unit with respect to the exposure beam.

19. The method of claim 18, wherein moving in said step (d) includes at least one of shifting, tilting, or rotating.

20. The method of claim 17, wherein said step (a) comprises coupling at least one element having optical power, the volume of immersion liquid, and the substrate into a single unit.

21. The method of claim 20, further comprising:

    (d) adjusting the volume of immersion liquid to alter at least one of resolution and depth of focus of the exposure beam.

22. The method of claim 17, wherein said step (a) comprises coupling at least one element having no optical power, the volume of immersion liquid, and the substrate into a single unit.

**23.** The method of claim 22, further comprising:

(d) adjusting the volume of immersion liquid to alter a depth of focus of the exposure beam.

Full field step and
scan

**FIG. 1**

200

202

220

204

206

208

214

212
216
218

210

Sub-field
step

Full field

**FIG. 2**

300

314

304

306

308

316

318

310

Full field step and
scan

FIG. 3

400

Couple at least one optical element, a volume of immersion liquid, and a substrate into a single unit. ∿402

Move the single unit with respect to an exposure beam carrying a pattern. ∿404

Move at least one optical compensation element to compensate for the movement of the single unit. ∿406

Expose the substrate through the single unit with the exposure beam ∿408

# FIG. 4

500

502

504

510

508

506

**FIG. 5**